# EUROPEAN PATENT APPLICATION

(11) **EP 4 633 332 A1**
(43) Date of publication of application: **15.10.2025**
(21) Application number: 23955419.9
(22) Date of filing: 11.10.2023
(51) Int. Cl.: H10K 30/50, H10F 71/00, H10K 30/40, H10K 30/88

(54) **BARRIER FILM AND SOLAR CELL EQUIPPED WITH SAME**

(71) Applicant: Kabushiki Kaisha Toshiba, Tokyo 105-0023 (JP); Toshiba Energy Systems & Solutions Corporation, Saiwai-ku Kawasaki-shi Kanagawa 2120013 (JP)
(72) Inventor: SHIDA, Naomi, Tokyo 105-0023 (JP); NAITO, Katsuyuki, Kawasaki-shi, Kanagawa 210-0024 (JP); TOBARI, Tomohiro, Kawasaki-shi, Kanagawa 212-0013 (JP)
(74) Representative: Marks & Clerk LLP
(86) International application number: PCT/JP2023/036862
(87) International publication number: WO 2025/079168

(57) **Abstract**

According to an embodiment, a barrier film having excellent gas barrier properties and excellent weather resistance and durability is provided. A barrier film according to the embodiment is a barrier film including: an inorganic barrier layer; and a sealing layer disposed to be in contact with a surface of the barrier layer, in which
the sealing layer contains a two-dimensional material, and
a zeta potential of a surface of the inorganic barrier layer in water at pH 6 and a zeta potential of a surface of the sealing layer in water at pH 6 have opposite signs.

## Description

### TECHNICAL FIELD

Embodiments of the present invention relate to a barrier film and a solar cell solar cell including the same.

### BACKGROUND ART

In recent years, expectations for solar cells using solar power generation have increased for environmental protection and prevention of global warming.

In conventional solar cells, a relatively thick (for example, about several mm) glass plate or the like is used as a substrate or a protective film. Therefore, the weight of the solar cell itself is heavy, and the places and facilities that can be installed are limited due to the restriction by the load bearing capacity.

Therefore, in recent years, a thin film solar cell having a light weight has attracted attention. As thin film solar cells, thin film silicon solar cells using Si thin films, CIGS-based solar cells using a copper-indium-gallium-selenium (CIGS) based thin film, CIS-based solar cells using a copper-indium-sulfur (CIS) based thin film, perovskite-based solar cells using a lead or tin-halogen monovalent cation thin film, and the like have been studied, and all of these solar cells are attracting attention as solar cells that can be expected to have high conversion efficiency.

The thin film solar cells as described above are also referred to as flexible thin film solar cells, since the thin film solar cells can be formed on resin films or metal thin films. Flexible thin film solar cells, being lightweight and excellent in flexibility, have fewer restrictions on installation locations compared to conventional solar cells, and can be freely installed, for example, on rooftops of large facilities or in locations with curved surfaces.

In addition, a thin film solar cell in which a light-transmissive barrier film is provided on the light receiving surface side has also been studied from the viewpoint of measures against weather degradation of the solar cell.

### CITATION LIST

### PATENT LITERATURE

Patent Literature 1: JP 2019-165144 A

### SUMMARY OF THE INVENTION

### OBJECT OF THE INVENTION

However, the barrier film used in the conventional thin film solar cell as described above tends to have insufficient gas barrier properties at the time of preparing or installing the solar cell and after long-term use, and further durability has been desired.

An object of the present embodiment is to provide a barrier film having sufficient gas barrier properties at the time of preparation, at the time of installation, and after long-term use, and a solar cell including the barrier film.

### SOLUTION TO PROBLEM

According to the present embodiment, the following invention is provided.
[1] A barrier film including: an inorganic barrier layer; and a sealing layer disposed to be in contact with a surface of the barrier layer, in which
   the sealing layer contains a two-dimensional material, and
   a zeta potential of a surface of the inorganic barrier layer in water at pH 6 and a zeta potential of a surface of the sealing layer in water at pH 6 have opposite signs.
[2] The barrier layer according to [1], in which the two-dimensional material is graphene or MXene.
[3] The barrier film according to [2], in which the graphene is polyalkyleneimine chain-bonded graphene.
[4] The barrier film according to [2] or [3], in which the graphene is nitrogen-doped graphene.
[5] The barrier film according to [2], in which the MXene is titanium carbide.
[6] The barrier film according to [2] or [5], in which the MXene contains a hydroxy group.
[7] The barrier film according to [2], [5], or [6], in which a nitrogen-containing compound is present on a surface of the MXene.
[8] The barrier film according to any one of [1] to [7], in which a sheet resistance of the sealing layer is 10⁴ to 10¹² Ω.
[9] The barrier film according to any one of [1] to [8], in which the sealing layer is formed of a two-dimensional material that swells with water vapor.
[10] The barrier film according to any one of [1] to [9], in which a surface of the sealing layer has a positive zeta potential in water at pH 6, and a surface of the barrier layer has a negative zeta potential in water at pH 6.
[11] The barrier film according to any one of [1] to [10], in which the sealing layer includes a laminated structure of the two-dimensional material, and an average number of layers of the laminated structure is 2 to 6.
[12] The barrier film according to any one of [1] to [11], in which an average particle size of the two-dimensional material is 1 to 20 µm.
[13] The barrier film according to any one of [1] to [12], in which a defect exists in the inorganic barrier layer.
[14] The barrier film according to any one of [1] to [13], in which the inorganic barrier layer contains a material selected from the group consisting of silicon oxide, silicon nitride, silicon carbide, aluminum oxide, titanium carbide, titanium oxide, zirconium oxide, and a composite thereof.
[15] The barrier film according to any one of [1] to [14], in which the inorganic barrier layer has a water vapor transmission rate of 10⁻³ (g/m²/day) or less.
[16] The barrier film according to any one of [1] to [15], further including an additional barrier layer, in which the barrier film has a structure in which the additional barrier layer, the inorganic barrier layer, and the sealing layer are laminated in this order.
[17] The barrier film according to [16], in which the inorganic barrier layer contains aluminum oxide or titanium oxide, and the additional barrier layer contains silicon oxide or silicon nitride.
[18] The barrier film according to any one of [1] to [17], further including an additional sealing layer, in which the barrier film has a structure in which the barrier layer, the sealing layer, and the additional sealing layer are laminated in this order.
[19] The barrier film according to [18], in which the sealing layer contains graphene and the additional sealing layer contains MXene.
[20] A solar cell including: a light absorbing layer; and the barrier film according to any one of [1] to [19] on a light incident side of the light absorbing layer.
[21] The solar cell according to [20], further including an ultraviolet absorbing layer.
[22] The solar cell according to [20] or [21], including a transparent electrode layer between the light absorbing layer and the barrier film.
[23] The solar cell according to any one of [20] to [22], in which the light absorbing layer contains halogen.

### BRIEF DESCRIPTION OF DRAWINGS

[Fig. 1] Fig. 1 is a cross-sectional view showing a barrier film of a first embodiment.
[Fig. 2] Fig. 2 is a cross-sectional view showing a solar cell of a second embodiment.
[Fig. 3] Fig. 3 is a cross-sectional view showing a barrier film of Example 1.
[Fig. 4] Fig. 4 is a cross-sectional view showing a barrier film of Example 2.
[Fig. 5] Fig. 5 is a cross-sectional view showing a barrier film of Example 3.
[Fig. 6] Fig. 6 is a cross-sectional view showing a barrier film of Example 4.
[Fig. 7] Fig. 7 is a cross-sectional view showing a solar cell of Example 6.
[Fig. 8] Fig. 8 is a cross-sectional view showing a solar cell of Example 7.

### BEST MODE FOR CARRYING OUT THE INVENTION

Hereinafter, a barrier film of an embodiment and a solar cell including the barrier film will be described with reference to the drawings. In the following description, components having the same or similar functions are denoted by the same reference numerals. Redundant descriptions of these configurations may be omitted. Note that the drawings are schematic or conceptual, and a relationship between a thickness and a width of each part, a ratio between sizes of parts, and the like are not necessarily the same as actual ones.

### [First Embodiment]

The first embodiment relates to a barrier film having high gas barrier properties and high resistance to moisture, and thus also having excellent weather resistance and durability.

Hereinafter, the configuration of the barrier film of the present embodiment will be described.

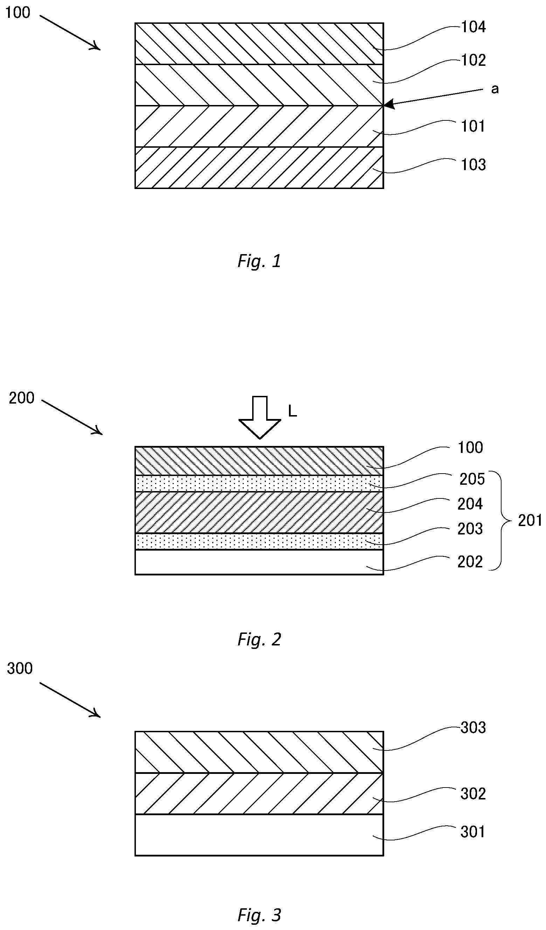

Fig. 1 is a cross-sectional conceptual diagram of a barrier film 10 according to the first embodiment. As illustrated in Fig. 1, a barrier film 100 according to the present embodiment is a composite material including an inorganic barrier layer 101 and a sealing layer 102 disposed in contact with the barrier layer 101. Here, the sealing layer 102 contains a two-dimensional material. The zeta potential of the surface of the inorganic barrier layer 101 in water at pH 6 and the zeta potential of the surface of the sealing layer 102 in water at pH 6 have opposite signs. The surface of the inorganic barrier layer 101 and the surface of the sealing layer 102 herein strictly mean their contact surface a, but the zeta potential of these surfaces is the same as the zeta potential of the surface of the material constituting the inorganic barrier layer or the sealing layer. Further, the barrier film according to the embodiment may include one or more additional barrier layers on the opposite side of the contact surface a of the inorganic barrier layer, and may include one or more additional sealing layers on the opposite side of the contact surface a of the sealing layer. Although an additional barrier layer 103 and an additional sealing layer 104 are described in Fig. 1 as examples, these may be omitted, and two or more additional barrier layers or additional sealing layers may be laminated, respectively.

### (Inorganic Barrier Layer and Additional Barrier Layer)

The inorganic barrier layer 101 contains a material selected from the group consisting of silicon oxide, silicon nitride, silicon carbide, aluminum oxide, titanium carbide, titanium oxide, zirconium oxide, and a composite thereof. The inorganic barrier layer may contain a binder material such as a polymer. In addition, it is preferable that the inorganic barrier layer and the polymer layer constitute a laminated structure because flexibility is easily improved. Furthermore, the inorganic barrier layer preferably has a low water vapor transmission rate (WVTR). Specifically, the WVTR is preferably 10⁻³ g/m²/day or less, and more preferably 10⁻⁴ g/m²/day or less. In the embodiment, the WVTR is measured at a temperature of 40°C and a humidity of 90% by the JIS Z0208 cup method.

One or more additional barrier layers may be further laminated on the opposite side of the contact surface a of the inorganic barrier layer. By using different materials for the inorganic barrier layer and the additional barrier layer, the gas barrier properties, the water vapor permeability, and the like can be further improved. The material of the additional barrier layer can be selected from the materials listed as the materials of the inorganic barrier layer. In particular, by using aluminum oxide or titanium oxide as the inorganic barrier layer and using silicon oxide or silicon nitride as the additional barrier layer, a strong structure can be obtained, and the gas barrier properties are also improved, which is preferable. Further, since the titanium oxide film has an ultraviolet absorbing effect, an ultraviolet preventing effect can be imparted to the barrier film.

The inorganic barrier layer may be installed on a base material (not shown). The base material may be glass or a resin such as polyethylene terephthalate (PET) or polyethylene naphthalate (PEN). When glass is used, it is preferable to use thin film glass having a thickness of 200 µm or less from the viewpoint of improving flexibility. From the viewpoint of weather resistance and fire resistance improvement, a base material containing a resin containing a halogen element is preferable, and the base material may be composed only of a resin containing a halogen element. As the resin constituting the base material, a resin having flame retardancy with an oxygen index of 22% or more is more preferably used, and examples thereof include polyvinyl chloride (PVC), polyvinylidene chloride (PVDC), a silicone resin, polyvinylidene fluoride (PVDF), polyimide (PI), and polycarbonate (PC). By using these as a base material, a barrier film having excellent flexibility and excellent weather resistance and fire resistance, and a solar cell including the barrier film can be obtained. The base material may be a composite material obtained by combining a plurality of members.

The film thickness of the base material is not particularly limited, but the film thickness of the resin base material may be in the range of 10 to 200 µm from the viewpoint of handling. The film thickness of the base material is preferably 30 to 150 µm.

### (Sealing Layer and Additional Sealing Layer)

In embodiments, the sealing layer contains a two-dimensional material. Two-dimensional materials are layered compounds bound by strong intra-layer covalent bonds and weak interlayer van der Waals forces. Such two-dimensional materials include graphene, single element structures (phosphorene, stannene, silicene, germanene); binary compounds (such as boron nitride and transition metal dichalcogenides (TMD)); clays; and two-dimensional carbides, nitrides, and carbonitrides known as MXenes. The material of the sealing layer can be selected in any manner from these two-dimensional materials and used depending on the purpose, and among them, graphene or MXene is preferably used. These materials have sufficiently high conductivity and an antistatic effect, and thus adhesion of impurities and the like can be prevented, which is preferable. In addition, graphene is preferable because graphene has high gas barrier properties.

The graphene has a skeleton in which carbon atoms are bonded in a planar manner, but is preferably chemically modified. One preferable graphene has a structure in which a polyalkyleneimine, particularly a polyethyleneimine chain is bonded as shown in the following formula.

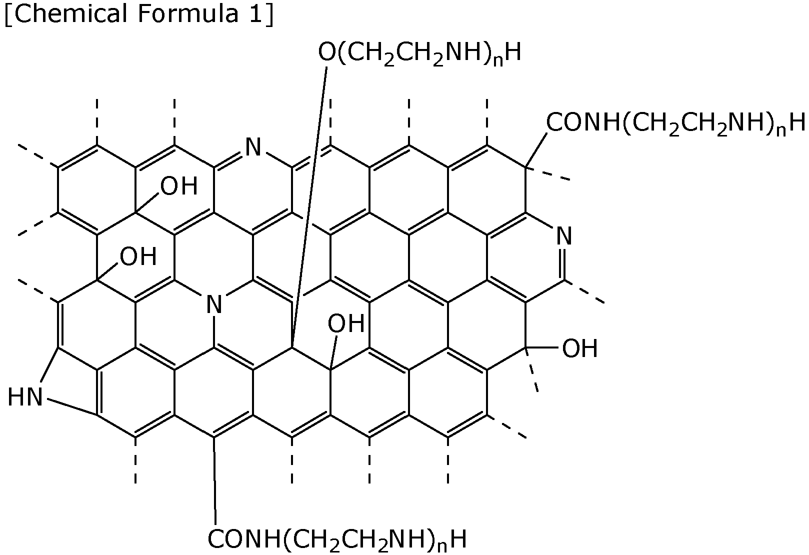

When the graphene has such a structure, water dispersibility is improved, and thus when a film is formed by coating, coating is facilitated, and the zeta potential can be made positive. When silicon oxide or silicon nitride is used for the inorganic barrier film, their zeta potentials are negative, and thus adhesion between the inorganic barrier layer and the sealing layer is improved, and thus the graphene preferably has a structure in which polyethyleneimine chains are bonded.

In the formula, a polyethyleneimine chain is exemplified as the polyalkyleneimine chain, but n is not particularly limited, but n is preferably n = 2 to 8, and particularly preferably n = 2. In addition to the linear polyalkyleneimine, a polyalkyleneimine having a branched chain or a cyclic structure can also be used.

It is also preferable that the carbon of the graphene skeleton is partially substituted with nitrogen. By substituting some of the carbon atoms constituting graphene with nitrogen, ion adsorbability can be improved.

In addition, MXene is a compound represented by the general formula:

Mₙ₊₁XₙTₓ.

In the formula, M is a pre-period transition metal such as Ti, V, or Nb, X is C or N, and T is a terminal group such as -OH, -O, or -Cl. Among them, titanium carbide in which M is Ti and X is C is preferable. By using titanium carbide, improvement in conductivity, barrier properties, and fire resistance can be expected. It is preferable that T is -OH and contains a hydroxy group. MXene having a hydroxy group has high water dispersibility, and thus is advantageous in the case of forming a sealing layer by coating, and is preferable because surface modification is facilitated. MXene having such a hydroxy group is preferable because the laminated structure of the MXene particles is easily maintained by interlayer hydrogen bonding. In addition, when a nitrogen-containing compound is present on the surface of the MXene particles, the zeta potential of the MXene can be made positive, or ions can be easily adsorbed, which is preferable.

In addition, one or more additional sealing layers may be further laminated on the opposite side of the contact surface a of the sealing layer. By using different materials for the sealing layer and the additional sealing layer, the gas barrier properties, the water vapor permeability, and the like can be further improved. The material of the additional sealing layer can be selected from the materials listed as the material of the sealing layer. In particular, use of graphene as the sealing layer and use of MXene as the additional sealing layer are preferable because the gas barrier properties are also improved.

In addition, when the sealing layer is formed of a two-dimensional material that swells with water vapor, the two-dimensional material swells when the sealing layer comes into contact with water vapor, the interval between particles is narrowed, and the water vapor transmission rate is easily reduced. Therefore, the sealing layer is preferably formed of a two-dimensional material that swells with water vapor.

Furthermore, it is preferable that the sealing layer includes a laminated structure of a two-dimensional material, and the average number of layers of the laminated structure is 2 to 6. When the average number of layers is within this range, both excellent gas barrier properties and excellent transparency can be achieved.

Furthermore, the sheet resistance of the sealing layer is preferably 10⁴ to 10¹² Q, and more preferably 10⁴ to 10⁸ Ω.

The sealing layer 102 contains the above-described two-dimensional material, but may be a layer further combined with a binder such as a resin. The binder is preferably a silicone resin, an epoxy resin, an olefin resin, or the like. The binder polymer is preferably dissolved or dispersed in a solvent dispersion of a two-dimensional material. A transparent and water-repellent material after application and drying is preferable. The zeta potential of the binder polymer in water at pH 6 has preferably the same sign as that of the two-dimensional material because dispersibility is good.

The two-dimensional material has excellent gas shielding properties at a part having no defect of itself, and is suitable as a material for forming the sealing layer. Further, the particles are particles having a shape with a high aspect ratio, specifically, a width in the order of µm and a thickness in the order of nm, and a flexible sealing layer having a large area can be easily formed by applying the dispersion.

The average particle size of the two-dimensional material in the width direction is preferably 1 to 20 µm. Accordingly, when there is a defect in the barrier layer, it is easy to seal the defect. When the average particle size is less than 1 µm, the barrier properties tend to deteriorate, and when the average particle size is more than 20 µm, dispersion in water tends to become difficult, and thus caution is required. The average particle size is preferably 5 to 10 µm. In the embodiment, the average particle size of the two-dimensional material particles can be measured by observing the coating dried film containing the two-dimensional material with an SEM.

### (Lamination of Inorganic Barrier Layer and Sealing Layer)

The inorganic barrier layer 101 has a high gas barrier properties if there is no defect, but when the inorganic barrier layer is bent or subjected to impact, cracks may occur, resulting in a reduction in barrier properties. In a solar cell or the like, impurities are likely to be mixed during manufacturing, and when a large area is required, cracks are likely to occur during handling.

Here, by laminating the inorganic barrier layer 101 and the sealing layer 102, particles of the two-dimensional material are disposed on defects present in the inorganic barrier layer 101, and the gas barrier properties can be improved by sealing the defects. In this case, by laminating the particles of the two-dimensional compound in two or more layers, the probability that defects can be sealed increases, and the gas barrier properties can be further improved. Even when there is no defect in the inorganic barrier layer 101, the particles of the two-dimensional material are bonded to the surface of the inorganic barrier layer by laminating the sealing layer 102, and thus it is possible to make defects hardly occur in the inorganic barrier layer even when stress is applied during handling. In addition, even when a defect occurs in the inorganic barrier layer during handling, the effect of sealing the defect is exhibited even when the defect is formed immediately below the particles of the two-dimensional material. When the film thickness of the sealing layer is increased, a moving distance of water vapor or the like passing through the barrier film becomes long, and thus the water vapor or the like hardly passes through the barrier film. However, when the film thickness is excessively large, light transmittance may be insufficient, and thus it is preferable to appropriately adjust the film thickness.

### (Effect of Zeta Potential)

When the surface of the inorganic barrier layer 101 and the surface of the sealing layer 102 have a zeta potential of opposite sign in water at pH 6, adhesiveness between the inorganic barrier layer 101 and the sealing layer 102 is increased, and peeling is less likely to occur. In addition, the two-dimensional material easily enters the defect of the inorganic barrier layer, and the deterioration of the barrier performance is easily prevented. For example, when the solar cell is disposed in an external environment, the solar cell is often exposed to weakly acidic rain containing carbon dioxide or the like, and thus it is important to focus on the zeta potential in water at pH 6. Preferably, a surface of the sealing layer has a positive zeta potential in water at pH 6, and a surface of the barrier layer has a negative zeta potential in water at pH 6.

The zeta potential in water generally varies when the pH is changed, but does not change rapidly. In general, when the pH increases, the zeta potential changes from a positive to a negative potential. The isoelectric point at which the potential becomes 0 varies depending on the material. A silicon oxide, a polymer having a carboxylic acid group, or the like in which protons are likely to be separated has a low pH (acidic) range at an isoelectric point, and a polymer having a basic amine group has a high pH (alkaline) range at an isoelectric point. Among polymers, those having a carbonyl group have an isoelectric point in an acidic range, and many polymers have a negative zeta potential at pH 6. Titanium oxide, aluminum oxide, and silicon nitride have an isoelectric point in a neutral or alkaline range, and generally have a positive zeta potential at pH 6. Graphene, MXene, clay, and the like of the two-dimensional compound generally have a negative zeta potential at pH 6. These zeta potentials can be changed by surface modification of each material. For example, the zeta potential can be made positive using a surface treatment agent having an amino group, or the zeta potential can be made negative using a surface treatment agent having a carboxylic acid group.

A strong barrier film can be formed by laminating a layer (barrier layer) of aluminum oxide or titanium oxide having a positive zeta potential on silicon oxide (additional barrier layer) having a negative zeta potential, further laminating a layer (sealing layer) of MXene having a negative zeta potential on the layer, and further laminating a layer (additional sealing layer) of graphene having a polyethyleneimine chain having a positive zeta potential bonded thereto.

The zeta potential on the surface of the flat plate sample can be measured by an electrophoretic light scattering method (ELS) using "Zetasizer Nano ZS" (manufactured by Malvern Panalytical Ltd.). Specifically, the measurement is performed using polystyrene latex as tracer particles by a flat plate zeta potential measuring cell. The pH at the time of measuring the zeta potential can be adjusted by adding dilute hydrochloric acid and a dilute aqueous potassium hydroxide solution to pure water.

Similarly, the zeta potential of the measurement target of the powder sample can be measured by an electrophoretic light scattering method (ELS) using "Zetasizer Nano ZS" (manufactured by Malvern Panalytical Ltd.). The cell used at this time is a capillary cell.

The zeta potential of each material at each contact interface of the inorganic barrier layer, the additional barrier layer, the sealing layer, and the additional sealing layer can be evaluated with a flat plate sample when each material can be peeled off at the interface. In addition, the evaluation can also be performed using a flat plate sample or a powder sample containing each material separately.

The barrier film may further include an ultraviolet absorbing layer. When a titanium oxide is used for the barrier layer, an ultraviolet absorbing effect is obtained, but light resistance can be further improved by further laminating an ultraviolet absorbing layer containing an amount of an ultraviolet absorber on, for example, the sealing layer or the additional sealing layer.

In addition, a transparent electrode layer may be provided on a side of the barrier layer opposite to the sealing layer. This makes it possible to reduce the number of members when an element such as a solar cell is prepared.

These auxiliary layers can be incorporated not only in the barrier film according to the embodiment but also in an element such as a solar cell including the barrier film.

The barrier film 100 according to the first embodiment has been described above.

The barrier film 100 according to the first embodiment can provide a flexible barrier film having excellent gas barrier properties and weather resistance and high durability.

### [Second Embodiment]

The second embodiment relates to a solar cell 200 including the barrier film according to the first embodiment. The solar cell according to the second embodiment can be formed by combining conventionally known structures in any manner except for including the barrier film according to the first embodiment.

As shown in Fig. 2, the solar cell 200 according to the embodiment has the barrier film 100 of the first embodiment on the light incident side, and further has a power generation unit 201 under the barrier film 100. It is preferable to use a power generation unit using a perovskite compound having a halogen as the light absorbing layer of the power generation unit 201 because the performance of the barrier film 100 can be most utilized.

### <Solar Cell Power Generation Unit>

The solar cell power generation unit 201 includes a substrate 202, a first electrode 203, a light absorbing layer 204, and a second electrode 205 in this order from the side opposite to the light receiving surface. An intermediate layer (for example, a hole transport layer, an electron injection layer, and the like) not illustrated may be included between the first electrode 203 and the light absorbing layer 204 or between the light absorbing layer 204 and the second electrode 205. In addition, a protective layer or another substrate not illustrated may be provided on the first electrode 203 or the second electrode 205 (that is, between the first electrode 203 and the substrate 202 and between the second electrode 205 and the barrier film 100).

Hereinafter, the solar cell power generation unit will be described in detail.

### (Substrate)

The substrate 202 is not particularly limited, but in order to secure flexibility, it is preferable to use a resin such as polyethylene terephthalate (PET), polyethylene naphthalate (PEN), polyvinyl chloride (PVC), polycarbonate (PC), polyvinylidene fluoride (PVDF), polyvinylidene chloride (PVDC), polyimide, or acrylic, an aluminum foil, or a stainless steel foil. The thickness of the substrate 1 is, for example, 50 µm to 200 µm.

### (First Electrode)

The first electrode 203 may be a metal film or a transparent electrode. In the case of a transparent electrode, a laminated film is preferable. For example, it is preferable that an oxide transparent conductive film containing Sn as a main component is provided as the first layer on the light absorbing layer 204 side, and a transparent conductive film having a resistance lower than that of the first layer is provided as the second layer on the substrate 202 side. The reason why the laminated film is preferable is that since the resistivity of the oxide transparent conductive film containing Sn as a main component as the first layer is higher than that of the second layer, when the first layer is used alone, the power generation loss due to the resistance component is large.

The first layer is preferably an oxide containing Sn as a main component, such as SnO₂. If necessary, additives may be included in the first layer. The additive is not limited, and examples thereof include Zn, Al, Ga, In, Si, Ge, Ti, Cu, Sb, Nb, F, and Ta.

Examples of the second layer can include indium tin oxide (ITO), aluminum-doped zinc oxide (AZO), boron-doped zinc oxide (BZO), gallium-doped zinc oxide (GZO), indium-doped zinc oxide (IZO), titanium-doped indium oxide (ITiO), indium gallium zinc oxide (IGZO), and hydrogen-doped indium oxide (In₂O₃), but is not particularly limited thereto. The transparent conductive film may be a laminated film, and a film such as tin oxide may be contained in the laminated film in addition to the oxide. As the first electrode 203, a laminate of a transparent conductive film and a metal film can also be used. The metal film having a thickness of 4 nm to 20 nm can be used as a transparent electrode. The transparent conductive film is as described above, but the metal film is not particularly limited, and may be a film of Al, Ag, stainless steel, Mo, Au, or W.

The first electrode may be a carbon-containing film (carbon nanotubes, graphene, graphite, and the like). These films have high stability and high resistance to humidity and halogen. However, since the resistance is higher than that of the metal film, it is preferable to add a metal auxiliary electrode.

The first electrode 203 is formed by a vacuum vapor deposition method, a sputtering method, an ion plating method, a plating method, a coating method, or the like. The thickness of the first electrode 203 may be appropriately determined according to the material to be used, but is preferably, for example, 50 nm to 250 nm. In the case of a carbon electrode, the thickness of the first electrode is preferably 10 µm to 50 µm.

### (Light Absorbing Layer)

The light absorbing layer 204 is not particularly limited as long as the light absorbing layer 204 is electromotive by incident sunlight, but a material having a perovskite structure (perovskite compound) can be used. A perovskite compound having a halogen element is preferable.

The perovskite structure includes, for example, an ion A1, an ion A2, and an ion X, and can be represented as A1A2X₃. When the ion A2 is smaller than the ion A1, the ion A2 may have a perovskite structure. The perovskite structure has, for example, a cubic unit lattice. The ion A1 is disposed at each vertex of the cubic crystal, and the ion A2 is disposed at the body center. The ions X are disposed at each face center of the cubic crystal around the ion A2 of the body center.

The orientation of the A2X₆ octahedron is easily distorted due to the interaction with the ion A1. Due to the decrease in symmetry, a Mott transition occurs, and a valence electron localized in the ion M can spread as a band. The ion A1 is preferably CH₃NH₃⁺. The ion A2 is preferably either Pb²⁺ or Sn²⁺. The ion X is preferably at least one of Cl⁻, Br⁻, and I⁻. Each of the materials constituting the ion A1, the ion A2, and the ion X may be a single material or a mixed material. The thickness of the light absorbing layer 204 is, for example, 200 nm to 800 nm.

When the light absorbing layer 204 is formed, it is preferable to adopt a coating method in which a material is dissolved in a solvent and applied onto an electrode (or an intermediate layer). According to the coating method, the light absorbing layer having a large area can be easily formed. Examples of the solvent to be used include unsaturated hydrocarbon-based solvents, halogenated aromatic hydrocarbon-based solvents, halogenated saturated hydrocarbon-based solvents, and ethers. Examples of the unsaturated hydrocarbon-based solvent include toluene, xylene, tetralin, decalin, mesitylene, n-butylbenzene, sec-butylbenzene, and tert-butylbenzene. Examples of the halogenated aromatic hydrocarbon-based solvent include chlorobenzene, dichlorobenzene, and trichlorobenzene. Examples of the halogenated saturated hydrocarbon-based solvent include carbon tetrachloride, chloroform, dichloromethane, dichloroethane, chlorobutane, bromobutane, chloropentane, chlorohexane, bromohexane, and chlorocyclohexane. Examples of the ethers include tetrahydrofuran and tetrahydropyran. It is more preferable to use a halogen-based aromatic solvent. Further, DMF(N,N-dimethylformamide), DMSO (dimethyl sulfoxide), 2-propanol, and γ-butyrolactone can also be used. These solvents can be used alone or in combination. The solvent is not particularly limited as long as the solvent can dissolve the material and does not impair the material.

Examples of the method for applying the solution include a spin coating method, a dip coating method, a casting method, a bar coating method, a roll coating method, a wire-bar coating method, a spray method, screen printing, a gravure printing method, a flexographic printing method, an offset printing method, gravure/offset printing, dispenser coating, a nozzle coating method, a capillary coating method, an inkjet method, and a meniscus coating method. These coating methods can be used alone or in combination.

### (Second Electrode)

The second electrode 205 preferably contains a transparent conductive material. The second electrode 205 of the present embodiment can be made of the same material as the first electrode 203. Similarly to the first electrode 203, the second electrode 205 can be formed by a vacuum vapor deposition method, a sputtering method, an ion plating method, a plating method, a coating method, or the like.

The configuration of the solar cell 200 according to the second embodiment has been described above.

The solar cell 200 according to the second embodiment includes the first embodiment having excellent gas barrier properties, and accordingly, a flexible thin film solar cell having excellent weather resistance and fire resistance and high durability can be provided.

The configuration, thickness, composition, and the like of each layer constituting the solar cell 200 according to the second embodiment may be appropriately changed within a range not hindering the above effect.

As described above, a protective film or the like may be provided between the solar cell power generation unit 201 and the barrier film 100, or the solar cell power generation unit 201 and the barrier film 100 may be in direct contact with each other.

According to at least the second embodiment described above, it is possible to provide a solar cell excellent in weather resistance and durability.

### Examples

Hereinafter, the present embodiment will be described more specifically with reference to examples, but the conditions in the examples are merely examples adopted to confirm the feasibility and effects of the present embodiment, and the present embodiment is not limited to these condition examples. The present embodiment can adopt various conditions as long as the object of the present embodiment is achieved without departing from the gist of the present embodiment.

### (Example 1)

A barrier film 300 having the structure shown in Fig. 3 is prepared.

First, a polycarbonate (PC) film having a thickness of 100 µm is prepared as a base material 301, and a barrier layer 302 made of a silicon oxide film having a thickness of 100 nm is prepared on the surface of the base material 301 by sputtering 3 times. The zeta potential of the silicon oxide film 302 in water at pH 6 is negative.

Next, a 0.05 wt% aqueous dispersion of single-layer graphene having a polyethyleneimine chain bonded thereto is applied onto the barrier layer 302 to prepare a sealing layer 303 including a graphene film having a thickness of about 2 nm. The absorbance shows that graphene has an average of about 3 layers. The zeta potential of the graphene film in water at pH 6 is positive.

The barrier film 300 obtained has an excellent barrier properties of 4x10⁻³ g/m²/day in WVTR, and the WVTR increases by 10% even when the bending test is performed 100 times with a glass rod having a diameter of 5 mm.

### (Comparative Example 1)

A barrier film is prepared in the same manner as in Example 1 except that a graphene film is not formed.

The WVTR of this barrier film has a barrier properties of 9×10⁻² g/m²/day, and when the bending test is performed 100 times with a glass rod having a diameter of 5 mm, the WVTR increases to 3×10⁻¹ g/m²/day.

### (Example 2)

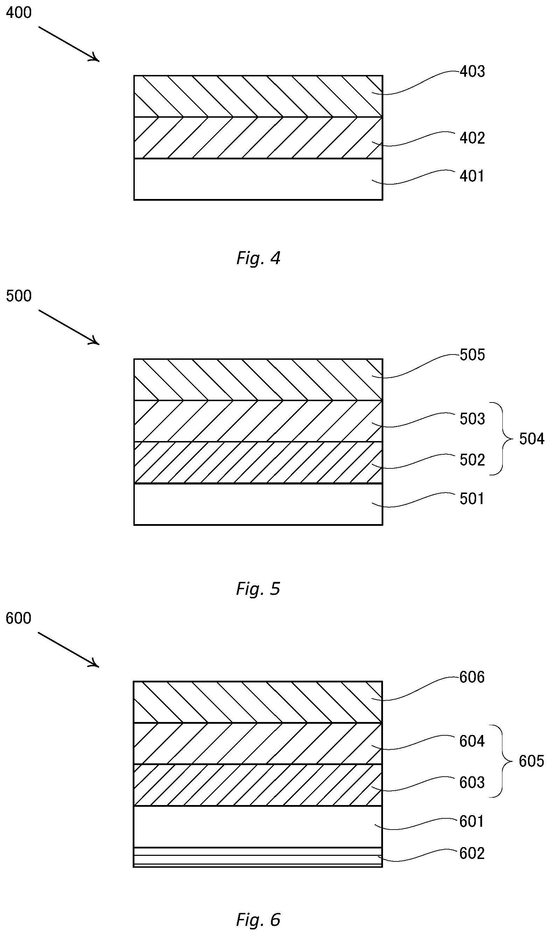

A barrier film 400 having the structure shown in Fig. 4 is prepared.

First, a polycarbonate (PC) film having a thickness of 60 µm is prepared as a base material 401, and the barrier layer 402 made of a silicon nitride film having a thickness of 200 nm is prepared on the surface of the base material 401 by a CVD method. The zeta potential of the barrier layer 402 in water at pH 6 is positive.

Next, on the barrier layer 402, an aqueous dispersion of 0.01 wt% of single-layer MXene (titanium carbide) having a hydroxy group on the surface having a negative zeta potential in water at pH 6 is applied, and a sealing layer 403 made of MXene and having a film thickness of about 2 nm is laminated.

The barrier film 400 obtained has an excellent barrier properties of 5×10⁻³ g/m²/day in WVTR, and the WVTR increases by 8% even when the bending test is performed 100 times with a glass rod having a diameter of 5 mm.

### (Comparative Example 2)

A barrier film is prepared in the same manner as in Example 2 except that a 0.05 wt% aqueous dispersion of single-layer graphene to which a polyethyleneimine chain having a positive zeta potential is bonded in water at pH 6 is applied instead of MXene to prepare a sealing layer composed of a graphene film having a thickness of about 2 nm.

The WVTR of this barrier film has a barrier properties of 6x10⁻³ g/m²/day, and when the bending test is performed 100 times with a glass rod having a diameter of 5 mm, the WVTR increases to 2×10⁻² g/m²/day.

### (Example 3)

A barrier film 500 having the structure shown in Fig. 5 is prepared.

First, a polyvinylidene fluoride (PVDF) film having a thickness of 50 µm is prepared as a base material 501, and a 0.5 wt% solution of polysilazane in hexane is applied to the surface of the base material 501. As a result, the barrier layer 54 made of the silicon nitride film 503 is prepared in a silicon oxide film 502 in the vicinity of the surface.

Next, an aqueous dispersion of 0.05 wt% of the single-layer graphene having a polyethyleneimine chain bonded thereto is applied onto the silicon oxide film 502 to prepare a sealing layer 505 made of a graphene film having a thickness of about 2 nm.

The barrier film 500 obtained has an excellent barrier properties of 6×10⁻⁴ g/m²/day in WVTR, and the WVTR increases by 10% even when the bending test is performed 100 times with a glass rod having a diameter of 5 mm.

### (Example 4)

A barrier film 600 having the structure shown in Fig. 6 is prepared.

First, a polyethylene phthalate (PET) film having a thickness of 100 µm is prepared as the base material 601, and a crystalline ITO film 602 having a thickness of 150 nm is prepared on the back surface. A silicon oxide film 603 having a thickness of 100 nm is prepared on the surface of the base material 601 by sputtering 3 times. A titanium oxide film 604 having a thickness of 50 nm is prepared thereon by sputtering 2 times to prepare a barrier layer 605. The zeta potential of the titanium oxide 603 in water at pH 6 is positive. The titanium oxide film is also an ultraviolet absorbing layer.

Next, an aqueous dispersion of 0.01 wt% of single-layer MXene (titanium carbide) having a hydroxy group on the surface is applied onto the barrier layer 605, and a sealing layer 606 made of MXene having a film thickness of about 2 nm is laminated.

The barrier film 60 obtained has an excellent barrier properties of 2×10⁻⁴ g/m²/day in WVTR, and the WVTR increases by 10% even when the bending test is performed 100 times with a glass rod having a diameter of 5 mm.

### (Example 5)

A barrier film is prepared in the same manner as in Example 4 except that an aluminum oxide is used instead of the titanium oxide film. Zeta potential in water of aluminum oxide pH 6 is positive.

The barrier film obtained has an excellent barrier properties of 5×10⁻⁴ g/m²/day in WVTR, and the WVTR increases by 15% even when the bending test is performed 100 times with a glass rod having a diameter of 5 mm.

### (Example 6)

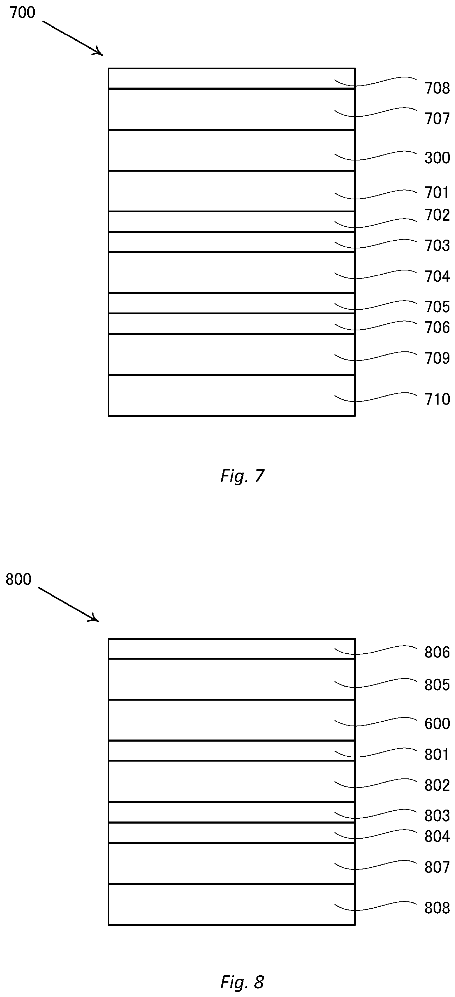

A solar cell (solar cell device) 700 illustrated in Fig. 7 is prepared.

A transparent electrode (second electrode) 72 of indium tin oxide (ITO) (200 nm) is prepared on a PC film (substrate 701) with a hard coat layer having a thickness of 100 µm by sputtering. A toluene solution of C₆₀-PCBM is applied onto the transparent electrode 702 with a bar coater and dried to form the electron injection layer 703.

Next, a solution in which lead iodide and methylammonium iodide are dissolved in a solvent is applied onto an electron injection layer 73, and then dried to form a light absorbing layer 74. A solution of 2,2',7,7'-Tetrakis[N,N-di(4-methoxyphenyl)amino]-9,9'-spirobifluorene (hereinafter, referred to as Spiro-OMeTAD) is then applied onto a light absorbing layer 704 and then dried to form a hole transport layer 705.

Next, a counter electrode (first electrode) 76 of molybdenum (Mo) is prepared on the hole transport layer 705 by sputtering.

The barrier film 300 obtained in Example 2 is attached onto the surface on the opposite side (that is, the light receiving side) to the transparent electrode (second electrode) 702 on the PC substrate 701. A silicone gel sealing material 707 is applied thereon, and a protective film (PVDF film) 708 is attached thereto. A silicone gel sealing material 709 is applied onto a first electrode (Mo electrode) 706, and an aluminum foil 710 is attached to prepare the solar cell 700. The periphery of the element is also sealed with a sealing material and an aluminum foil (not shown).

The solar cell 700 obtained exhibits an energy conversion efficiency of about 12% for 1SUN sunlight, and even when the bending test is performed 100 times with a glass rod having a diameter of 5 mm, the reduction in efficiency is 5%. Furthermore, even after being left for 1,000 hours at a humidity of 85% and a temperature of 85°C, the decrease in efficiency is 10%.

### (Example 7)

A solar cell (solar cell device) 800 illustrated in Fig. 8 is prepared.

An electron injection layer 802 made of tin oxide is formed on the ITO transparent electrode (second electrode) of the barrier film 600 obtained in Example 4 by sputtering. Next, a solution in which lead iodide and methylammonium iodide are dissolved in a solvent is applied onto an electron injection layer 801, and then dried to form the light absorbing layer 802. Subsequently, a solution of Spiro-OMeTAD is applied onto the light absorbing layer 802, and then dried to form a hole transport layer 803.

Next, an Au electrode (first electrode) 804 is prepared on the hole transport layer 803 by vapor deposition. A silicone gel sealing material 805 is applied onto the barrier film, and a protective film (PVDF film) 806 is further attached. A silicone gel sealing material 807 is applied onto the Au electrode, and an aluminum foil 808 is attached to prepare the solar cell 800. The periphery of the element is also sealed with a sealing material and an aluminum foil (not shown).

The solar cell 800 obtained exhibits an energy conversion efficiency of about 14% for 1SUN sunlight, and even when the bending test is performed 100 times with a glass rod having a diameter of 5 mm, the reduction in efficiency is 5%. Furthermore, even after being left for 1,000 hours at a humidity of 85% and a temperature of 85°C, the decrease in efficiency is 8%.

Some embodiments of the present invention have been described above, these embodiments are presented as examples and do not limit the scope of the invention. These embodiments can be implemented in various other forms, and various omissions, substitutions, changes, additions, or the like can be made without departing from the gist of the invention. These embodiments and modifications are included in the scope and gist of the invention, and are included in the invention described in claims and the equivalent scope thereof.

### REFERENCE SIGNS LIST

100, 300, 400, 500, 600 Barrier film
200, 700, 800 Solar cell
101, 302, 504, 605 Barrier layer
102, 303, 606 Sealing layer
103, 104 Contact surface
105, 301, 401, 501, 601 Base material
201 Solar cell power generation unit
202, 701 Substrate
203, 706, 804 First electrode
204, 704, 802 Light absorbing layer
205, 702 Second electrode
502, 603 Silicon oxide film
503 Silicon nitride film
604 Titanium oxide film
703, 801 Electron injection layer
705, 803 Hole transport layer
602 Crystalline ITO film
707, 709, 805, 807 Sealing material
708, 806 Protective film
710, 808 Aluminum foil

## Claims

1. A barrier film comprising: an inorganic barrier layer; and a sealing layer disposed to be in contact with a surface of the barrier layer, wherein
said sealing layer contains a two-dimensional material, and
a zeta potential of a surface of said inorganic barrier layer in water at pH 6 and a zeta potential of a surface of said sealing layer in water at pH 6 have opposite signs.

2. The barrier layer according to claim 1, wherein said two-dimensional material is graphene or MXene.

3. The barrier film according to claim 2, wherein said graphene is polyalkyleneimine chain-bonded graphene.

4. The barrier film according to claim 2, wherein said graphene is nitrogen-doped graphene.

5. The barrier film according to claim 2, wherein said MXene is titanium carbide.

6. The barrier film according to claim 2, wherein said MXene contains a hydroxy group.

7. The barrier film according to claim 2, wherein a nitrogen-containing compound is present on a surface of said MXene.

8. The barrier film according to claim 1 or 2, wherein a sheet resistance of said sealing layer is 10⁴ to 10¹² Ω.

9. The barrier film according to claim 1 or 2, wherein said sealing layer is formed of a two-dimensional material that swells with water vapor.

10. The barrier film according to claim 1 or 2, wherein a surface of said sealing layer has a positive zeta potential in water at pH 6, and a surface of said barrier layer has a negative zeta potential in water at pH 6.

11. The barrier film according to claim 1 or 2, wherein said sealing layer includes a laminated structure of said two-dimensional material, and an average number of layers of said laminated structure is 2 to 6.

12. The barrier film according to claim 1 or 2, wherein an average particle size of said two-dimensional material is 1 to 20 µm.

13. The barrier film according to claim 1 or 2, wherein a defect exists in said inorganic barrier layer.

14. The barrier film according to claim 1 or 2, wherein said inorganic barrier layer contains a material selected from the group consisting of silicon oxide, silicon nitride, silicon carbide, aluminum oxide, titanium carbide, titanium oxide, zirconium oxide, and a composite thereof.

15. The barrier film according to claim 1 or 2, wherein said inorganic barrier layer has a water vapor transmission rate of 10⁻³ (g/m²/day) or less.

16. The barrier film according to claim 1 or 2, further comprising an additional barrier layer, wherein said barrier film has a structure in which said additional barrier layer, said inorganic barrier layer, and said sealing layer are laminated in this order.

17. The barrier film according to claim 16, wherein said inorganic barrier layer contains aluminum oxide or titanium oxide, and said additional barrier layer contains silicon oxide or silicon nitride.

18. The barrier film according to claim 1 or 2, further comprising an additional sealing layer, wherein said barrier film has a structure in which said barrier layer, said sealing layer, and said additional sealing layer are laminated in this order.

19. The barrier film according to claim 18, wherein said sealing layer contains graphene and said additional sealing layer contains MXene.

20. A solar cell comprising: a light absorbing layer; and said barrier film according to claim 1 or 2 on a light incident side of said light absorbing layer.

21. The solar cell according to claim 20, further comprising an ultraviolet absorbing layer.

22. The solar cell according to claim 20, comprising a transparent electrode layer between said light absorbing layer and said barrier film.

23. The solar cell according to claim 20, wherein said light absorbing layer contains halogen.
